# EUROPEAN PATENT APPLICATION

(11) **EP 4 606 990 A1**
(43) Date of publication of application: **27.08.2025**
(21) Application number: 25159161.6
(22) Date of filing: 20.02.2025
(51) Int. Cl.: E21B 49/00

(54) **IN-SITU STRESS DETERMINATION TECHNIQUES USING A GEOMECHANICAL MODEL**

(30) Priority: 22.02.2024 US 202463556473 P
(71) Applicant: Services Pétroliers Schlumberger, 75007 Paris (FR); Schlumberger Technology B.V., 2514 JG The Hague (NL)
(72) Inventor: KARPFINGER, Florian, Bandar Utama Petaling Jaya (MY); DONALD, John Adam, 9261 Dubai (AE); GISOLF, Adriaan, 060201 Bucharest (RO); DIAZ GRANADOS PERTUZ, Ivan, 34000 Montpellier (FR)
(74) Representative: Schlumberger Intellectual Property Department

(57) **Abstract**

Systems and methods presented herein provide for in-situ stress test. For example, the systems and methods may include receiving inputs comprising one or more geomechanical model parameters corresponding to a subterranean formation, well logs corresponding to the subterranean formation, or both; generating a geomechanics model using the one or more geomechanical model parameters; receiving one or more tool-string specifications; generating a stress test plan based on the geomechanical model and the tool-string specifications; setting upper and lower packers (36) of an in-situ stress testing tool (24) at a target depth within a wellbore traversing the subterranean formation; and injecting fluid from the in-situ stress testing tool into the subterranean formation at a downhole location within a first interval between the upper and lower packers to create and/or propagate a fracture within the subterranean formation in accordance with the stress test plan.

## Description

### CROSS-REFERENCE TO RELATED APPLICATIONS

This application claims the benefit of U.S. Provisional Application No. 63/556473, filed February 22, 2024.

### BACKGROUND

The present disclosure generally relates to systems and methods for improving the accuracy of stress testing operations in real-time (RT).

This section is intended to introduce the reader to various aspects of art that may be related to various aspects of the present techniques, which are described and/or claimed below. This discussion is believed to be helpful in providing the reader with background information to facilitate a better understanding of the various aspects of the present disclosure. Accordingly, it should be understood that these statements are to be read in this light, and not as an admission of any kind.

Downhole acquisition tools are used to extract quantitative information of formation rock stresses during certain drilling operations. The formation rock stress information may facilitate predicting geo-mechanical problems that may be associated with a wellbore of interest. For example, vertical stress, minimum horizontal stress, maximum horizontal stress, and azimuth of minimum horizontal stress are geo-stresses that may be used to characterize formation rock stress. These stress parameters may be estimated using various techniques. For example, vertical stress may be estimated from an integral of a density log obtained using the downhole acquisition tool. Minimum horizontal stress may be estimated using fracturing techniques and/or leak-off data, and its direction from borehole caliper or image analysis. During formation testing to estimate the minimum horizontal stress of the formation rock, the downhole acquisition tool injects a fluid into the formation to create a fracture. In particular, the downhole acquisition tool pumps a fluid into the formation, thereby causing a local increase in pressure at the injection site. The pressure continues to buildup until the formation rock mechanically fails and fractures. In certain instances, existing formation rock fractures may be reopened by injecting the fluid into the existing fractures. Following fracture, the injected fluid exits the fracture and a closure event (e.g., closing of the fracture) occurs. The minimum horizontal stress of the formation rock may be determined based on fracture closure pressure (e.g., the amount of pressure observed when the fracture closed).

### SUMMARY

A summary of certain embodiments described herein is set forth below. It should be understood that these aspects are presented merely to provide the reader with a brief summary of these certain embodiments and that these aspects are not intended to limit the scope of this disclosure.

Certain embodiments of the present disclosure include a method that includes receiving one or more geomechanical model parameters corresponding to a subterranean formation; generating a geomechanics model using the one or more geomechanical model parameters; receiving one or more tool-string specifications; generating a stress test based on the geomechanics model and the tool-string specifications; setting upper and lower packers of an in-situ stress testing tool at a target depth within a wellbore traversing the subterranean formation; and injecting fluid from the in-situ stress testing tool into the subterranean formation at a downhole location within a first interval between the upper and lower packers to create and/or propagate a fracture within the subterranean formation in accordance with the stress test.

Various refinements of the features noted above may be undertaken in relation to various aspects of the present disclosure. Further features may also be incorporated in these various aspects as well. These refinements and additional features may exist individually or in any combination. For instance, various features discussed below in relation to one or more of the illustrated embodiments may be incorporated into any of the above-described aspects of the present disclosure alone or in any combination. The brief summary presented above is intended to familiarize the reader with certain aspects and contexts of embodiments of the present disclosure without limitation to the claimed subject matter.

### BRIEF DESCRIPTION OF THE DRAWINGS

Various aspects of this disclosure may be better understood upon reading the following detailed description and upon reference to the drawings, in which:
FIG. 1 illustrates an in-situ stress testing tool being suspended in a wellbore traversing a formation by a cable, in accordance with embodiments of the present disclosure;
FIG. 2 illustrates a surface control system that may control the oil and gas well system of FIG. 1, in accordance with embodiments of the present disclosure;
FIG. 3 illustrates an embodiment of a tool control system illustrated in FIG. 1, in accordance with embodiments of the present disclosure;
FIG. 4 illustrates an example process for implement the disclosed stress test using the in-situ stress testing tool of FIG. 1, in accordance with embodiments of the present disclosure;
FIG. 5 shows a window having representative input data that may be used to generate a model using the flow of FIG. 4, in accordance with embodiments of the present disclosure;
FIG. 6 shows a window displaying geomechanical model parameters that may be utilized in the process of FIG. 4, in accordance with embodiments of the present disclosure;
FIG. 7 shows a window including tool string specifications that may be used to control the in-situ stress testing tool of FIG. 1, in accordance with embodiments of the present disclosure;
FIG. 8 shows a window illustrating a determined risk profile, in accordance with embodiments of the present disclosure; and
FIG. 9 shows a stress test planner summary, in accordance with embodiments of the present disclosure.

### DETAILED DESCRIPTION

One or more specific embodiments of the present disclosure will be described below. These described embodiments are only examples of the presently disclosed techniques. Additionally, in an effort to provide a concise description of these embodiments, all features of an actual implementation may not be described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present disclosure, the articles "a," "an," and "the" are intended to mean that there are one or more of the elements. The terms "comprising," "including," and "having" are intended to be inclusive and mean that there may be additional elements other than the listed elements. Additionally, it should be understood that references to "one embodiment" or "an embodiment" of the present disclosure are not intended to be interpreted as excluding the existence of additional embodiments that also incorporate the recited features.

As used herein, the terms "connect," "connection," "connected," "in connection with," and "connecting" are used to mean "in direct connection with" or "in connection with via one or more elements"; and the term "set" is used to mean "one element" or "more than one element." Further, the terms "couple," "coupling," "coupled," "couple d together," and "coupled with" are used to mean "directly coupled together" or "coupled together via one or more elements." As used herein, the terms "up" and "down," "uphole" and "downhole", "upper" and "lower," "top" and "bottom," and other like terms indicating relative positions to a given point or element are utilized to more clearly describe some elements. Commonly, these terms relate to a reference point as the surface from which drilling operations are initiated as being the top (e.g., uphole or upper) point and the total depth along the drilling axis being the lowest (e.g., downhole or lower) point, whether the well (e.g., wellbore, borehole) is vertical, horizontal or slanted relative to the surface.

In addition, as used herein, the terms "real time", "real-time", or "substantially real time" may be used interchangeably and are intended to describe operations (e.g., computing operations) that are performed without any human-perceivable interruption between operations. For example, as used herein, data relating to the systems described herein may be collected, transmitted, and/or used in control computations in "substantially real time" such that data readings, data transfers, and/or data processing steps occur once every second, once every 0.1 second, once every 0.01 second, or even more frequently, during operations of the systems (e.g., while the systems are operating). In addition, as used herein, the terms "continuous", "continuously", or "continually" are intended to describe operations that are performed without any significant interruption. For example, as used herein, control commands may be transmitted to certain equipment every five minutes, every minute, every 30 seconds, every 15 seconds, every 10 seconds, every 5 seconds, or even more often, such that operating parameters of the equipment may be adjusted without any significant interruption to the closed-loop control of the equipment. In addition, as used herein, the terms "automatic", "automated", "autonomous", and so forth, are intended to describe operations that are performed are caused to be performed, for example, by a computing system (i.e., solely by the computing system, without human intervention).

The present disclosure relates to techniques for improving the success of stress testing. In particular, it is presently recognized that the success of a stress test depends on, for example, the selection of dual packer hardware. Selecting the correct dual packer hardware may ensure that the relevant pressure is applied for breakdown of the formation. To select the correct dual packer hardware, it is further recognized that it is advantageous to utilize the geomechanical subsurface properties of the surrounding subterranean formation, which define the pressure for breakdown of the formation.

In general, the disclosed techniques provide a workflow which may provide de-risking (e.g., increased chance of success (CoS)) of stress testing operations by selecting relevant packers for a particular geological environment. Additionally or alternatively, the disclosed techniques may provide a seamless calibration of a 1D geomechanical model in real time (RT) or substantially close to RT, thereby providing input for injection planning that may occur at the end of the stress testing operation. The disclosed techniques include one or more of generating a geomechanics model, generating a stress test plan based on the geomechanics model, and performing a micro fracture operation using the stress test plan. To generate the geomechanics model, one or more processors may receive tool string specifications (e.g., packer type(s), mandrel type(s), pump type(s), flow line properties, and the like), subterranean properties (e.g., lithology information, depth, stress gradient information, borehole diameter, mud-cake coefficient(s), and the like), or a combination thereof. After generating the geomechanics model (e.g., pre-frac model), the one or more processors may generate a stress testing plan that indicates a pressure for operating a micro-fracturing operation. During the micro-fracturing operations, specific station depth points are determined using the initial 1D model generated from sonic, image, petrophysics, pressure and drilling data, and then updated after each stress testing point. At the end of the micro-fracturing operation (e.g., the actual stress testing program), the stress profile is updated using automated stress inversion technique to determine the far field tectonic strains uses in the poro-elastic model.

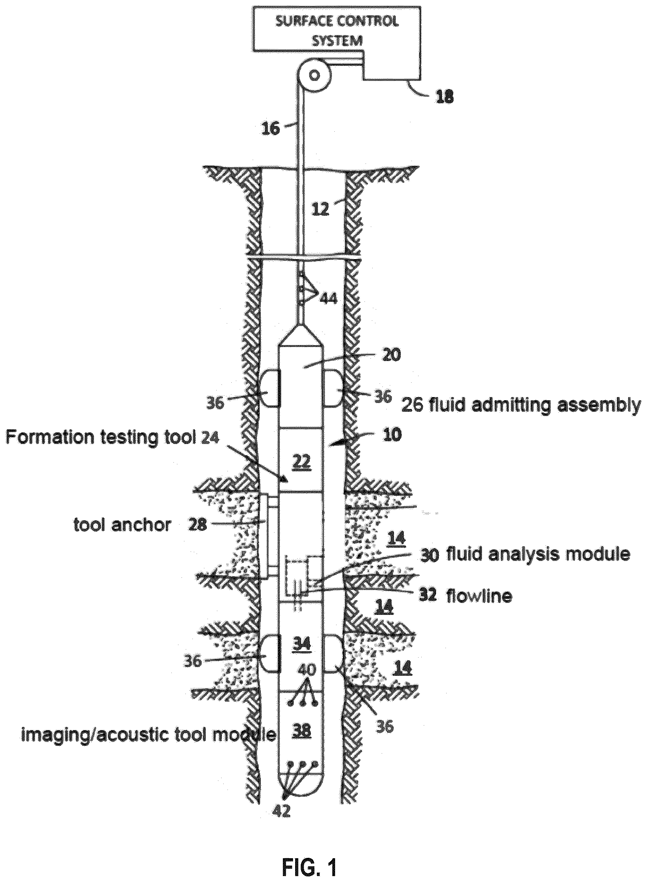

FIG. 1 illustrates an in-situ stress testing tool 10 being suspended in a wellbore 12 traversing a subterranean formation 14 by a cable 16 that is spooled in a usual fashion on a suitable winch (not shown) on the formation surface. On the surface, the cable 16 may be electrically coupled to a surface control system 18 that is configured to at least partially control operation of the in-situ stress testing tool 10 by communicating data and control signals to and from the in-situ stress testing tool 10 via the cable 16, as described in greater detail herein. Although described primarily herein as using a cable 16 (e.g., wireline cable) to convey the in-situ stress testing tool 10 into the wellbore 12, in other embodiments, other types of tool conveyance systems may be used to convey the in-situ stress testing tool 10 into the wellbore 12, such as coiled tubing, pipe conveyance, and so forth. As illustrated, in certain embodiments, the in-situ stress testing tool 10 includes an elongated body 20 that encloses a tool control system 22 that is configured to communicate with the surface control system 18 for the purpose of controlling operation of the in-situ stress testing tool 10, as described in greater detail herein.

In particular, as described in greater detail herein, the in-situ stress testing tool 10 may include a formation testing tool module 24 that includes a fluid admitting assembly 26 and a tool anchoring member 28, which may be arranged on opposite lateral sides of the body 20. In certain embodiments, the formation testing tool module 24 may include a fluid sampling probe module. In such embodiments, the fluid sampling probe module may be above the dual packer elements or below the dual packer elements (e.g., relative to the direction of the wellbore 12 away from the surface). In addition, in certain embodiments, the formation testing tool module 24 of the in-situ stress testing tool 10 may include a fluid analysis module 30 with a flow line 32 through which fluid collected from the subterranean formation 14 flows. The fluid may thereafter be expelled through a port (not shown) or may be directed to one or more fluid collecting chambers 34 of the formation testing tool module 24, which may receive and retain the fluids collected from the subterranean formation 14 or wellbore 12. As described in greater detail herein, the fluid admitting assembly 26, the fluid analysis module 30, and the flow path to the fluid collecting chambers 34 of the formation testing tool module 24 may be controlled by the control systems 18, 22.

In-situ stress testing in accordance with the disclosed embodiments may be performed with dual-packers (e.g., a packer element for sleeve fracturing or two dual packers for hydraulic fracturing), that are configured to inflate against the wellbore 12 to, for example, provide a seal between the inflatable packers 36 between the inflatable packers and the wellbore 12.. At least in some instances, the in-situ stress testing tool 10 may use a single inflatable packer 36.. In addition, in certain embodiments, the one or more inflatable packers 36 may isolate portions of the wellbore 12 to facilitate the collection of fluids via the in-situ stress testing tool 10. Although illustrated in FIG. 1 as including an in-situ stress testing tool 10 held in place within the wellbore 12 by one or more inflatable packers 36, in other embodiments, one or more inflatable packers 36 may isolate other types of downhole tools (e.g., other types of formation testing tools, imaging/acoustic tools, and so forth) within the wellbore 12.

Furthermore, as described in greater detail herein, in certain embodiments, the in-situ stress testing tool 10 may include an imaging and/or acoustic tool module 38, which may be used in combination with the formation testing tool module 24 to form an in-situ stress testing tool 10 that combines formation testing capabilities with imaging and/or acoustic imaging capabilities, as described in greater detail herein. For example, in certain embodiments, the imaging and/or acoustic tool module 38 may include one or more transmitters 40 that may be configured to generate waves that may be detected by one or more receivers 42 of the imaging and/or acoustic tool module 38 itself and/or one or more receivers 44 that are disposed on the cable 16, are part of the cable 16, or are disposed elsewhere on the in-situ stress testing tool 10. In general, the generated waves may be detected by the receivers 42, 44 for the purpose of characterizing the formation 14, as described in greater detail herein.

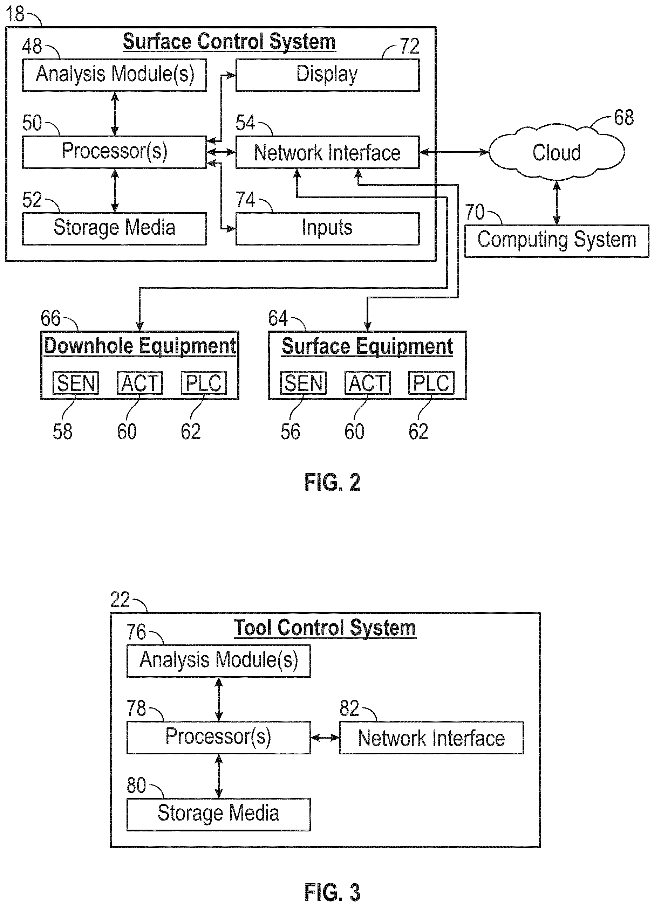

FIG. 2 illustrates an embodiment of the surface control system 18 illustrated in FIG. 1. In certain embodiments, the surface control system 18 may include one or more analysis modules 48 (e.g., a program of processor executable instructions and associated data) that may be configured to perform various functions of the embodiments described herein. In certain embodiments, to perform these various functions, an analysis module 48 executes on one or more processors 50 of the surface control system 18, which may be connected to one or more storage media 52 of the surface control system 18. Indeed, in certain embodiments, the one or more analysis modules 48 may be stored in the one or more storage media 52.

In certain embodiments, the one or more processors 50 may include a microprocessor, a microcontroller, a processor module or subsystem, a programmable integrated circuit, a programmable gate array, a digital signal processor (DSP), or another control or computing device. In certain embodiments, the one or more storage media 52 may be implemented as one or more non-transitory computer-readable or machine-readable storage media. In addition, in certain embodiments, the one or more storage media 52 may include one or more different forms of memory including semiconductor memory devices such as dynamic or static random access memories (DRAMs or SRAMs), erasable and programmable read-only memories (EPROMs), electrically erasable and programmable read-only memories (EEPROMs) and flash memories; magnetic disks such as fixed, floppy and removable disks; other magnetic media including tape; optical media such as compact disks (CDs) or digital video disks (DVDs); or other types of storage devices. Note that the processor-executable instructions and associated data of the analysis module(s) 48 may be provided on one computer-readable or machine-readable storage medium of the storage media 52 or, alternatively, may be provided on multiple computer-readable or machine-readable storage media distributed in a large system having possibly plural nodes. Such computer-readable or machine-readable storage medium or media are considered to be part of an article (or article of manufacture), which may refer to any manufactured single component or multiple components. In certain embodiments, the one or more storage media 52 may be located either in the machine running the machine-readable instructions, or may be located at a remote site from which machine-readable instructions may be downloaded over a network for execution.

In certain embodiments, the processor(s) 50 may be connected to a network interface 54 of the surface control system 18 to allow the surface control system 18 to communicate with various surface sensors 56 and/or downhole sensors 58 described herein, as well as communicate with various actuators 60 and/or PLCs 62 of surface equipment 64 (e.g., surface pumps, valves, and so forth) and/or of downhole equipment 66 (e.g., the formation testing tool module 24 of the in-situ stress testing tool 10, the imaging and/or acoustic tool module 38 of the in-situ stress testing tool 10, the inflatable packers 36, electric submersible pumps, other downhole tools, and so forth) for the purpose of controlling operation of the oil and gas well system illustrated in FIG. 1. In certain embodiments, the network interface 54 may also facilitate the surface control system 18 to communicate data to a cloud-based service 68 (or other wired and/or wireless communication network) to, for example, archive the data or to enable external computing systems 70 (e.g., cloud-based computing systems, in certain embodiments) to access the data and/or to remotely interact with the surface control system 18. For example, in certain embodiments, some or all of the analysis modules 48 described in greater detail herein may be executed via cloud and edge deployments.

In certain embodiments, the surface control system 18 may include a display 72 configured to display a graphical user interface to present results of the operations described herein. In addition, in certain embodiments, the graphical user interface may present other information to operators of the equipment 64, 66 described herein. For example, the graphical user interface may include a dashboard configured to present visual information to the operators. In certain embodiments, the dashboard may show live (e.g., real-time) data as well as the results of the operations described herein.

In addition, in certain embodiments, the surface control system 18 may include one or more input devices 74 configured to enable operators to, for example, provide commands to the equipment 64, 66 described herein. For example, in certain embodiments, the in-situ stress testing tool 10 may provide information to the operators regarding the formation testing operations, and the operators may implement actions relating to the formation testing operations by manipulating the one or more input devices 74, as described in greater detail herein. In certain embodiments, the display 72 may include a touch screen interface configured to receive inputs from operators. For example, an operator may directly provide instructions to the in-situ stress testing tool 10 via the user interface, and the instructions may be output to the in-situ stress testing tool 10 via a controller and a communication system of the in-situ stress testing tool 10.

It should be appreciated that the surface control system 18 illustrated in FIG. 2 is only one example of a well control system, and that the surface control system 18 may have more or fewer components than shown, may combine additional components not depicted in the embodiment of FIG. 2, and/or the surface control system 18 may have a different configuration or arrangement of the components depicted in FIG. 2. In addition, the various components illustrated in FIG. 2 may be implemented in hardware, software, or a combination of both hardware and software, including one or more signal processing and/or application specific integrated circuits. Furthermore, the operations of the surface control system 18 as described herein may be implemented by running one or more functional modules in an information processing apparatus such as application specific chips, such as application-specific integrated circuits (ASICs), field-programmable gate arrays (FPGAs), programmable logic devices (PLDs), systems on a chip (SOCs), or other appropriate devices. These modules, combinations of these modules, and/or their combination with hardware are all included within the scope of the embodiments described herein.

In addition, as described above, the in-situ stress testing tool 10 may include a tool control system 22 (not shown) that controls the local functionality of the in-situ stress testing tool 10 and, in certain embodiments, the inflatable packers 36, as described in greater detail herein. In certain embodiments, the tool control system 22 of the in-situ stress testing tool 10 may communicate with the surface control system 18 such that the control systems 18, 22 collectively control operation of the in-situ stress testing tool 10 and/or the inflatable packers 36. As will be appreciated, the tool control system 22 of the in-situ stress testing tool 10 may include components that are substantially similar to the components of the surface control system 18 illustrated in FIG. 2, other than the display 72 and the input devices 74.

FIG. 3 illustrates an embodiment of the tool control system 22 illustrated in FIG. 1. In certain embodiments, the tool control system 22 may include one or more analysis modules 76 (e.g., a program of processor executable instructions and associated data) that may be configured to perform various functions of the embodiments described herein. In certain embodiments, to perform these various functions, an analysis module 76 executes on one or more processors 78 of the tool control system 22, which may be connected to one or more storage media 80 of the tool control system 22. Indeed, in certain embodiments, the one or more analysis modules 76 may be stored in the one or more storage media 80.

In certain embodiments, the one or more processors 78 may include a microprocessor, a microcontroller, a processor module or subsystem, a programmable integrated circuit, a programmable gate array, a digital signal processor (DSP), or another control or computing device. In certain embodiments, the one or more storage media 80 may be implemented as one or more non-transitory computer-readable or machine-readable storage media. In addition, in certain embodiments, the one or more storage media 80 may include one or more different forms of memory including semiconductor memory devices such as dynamic or static random access memories (DRAMs or SRAMs), erasable and programmable read-only memories (EPROMs), electrically erasable and programmable read-only memories (EEPROMs) and flash memories; or other types of storage devices. Such computer-readable or machine-readable storage medium or media are considered to be part of an article (or article of manufacture), which may refer to any manufactured single component or multiple components. In addition, in certain embodiments, the processor(s) 78 may be connected to a network interface 82 of the tool control system 22 to allow the tool control system 22 to communicate with the surface control system 18.

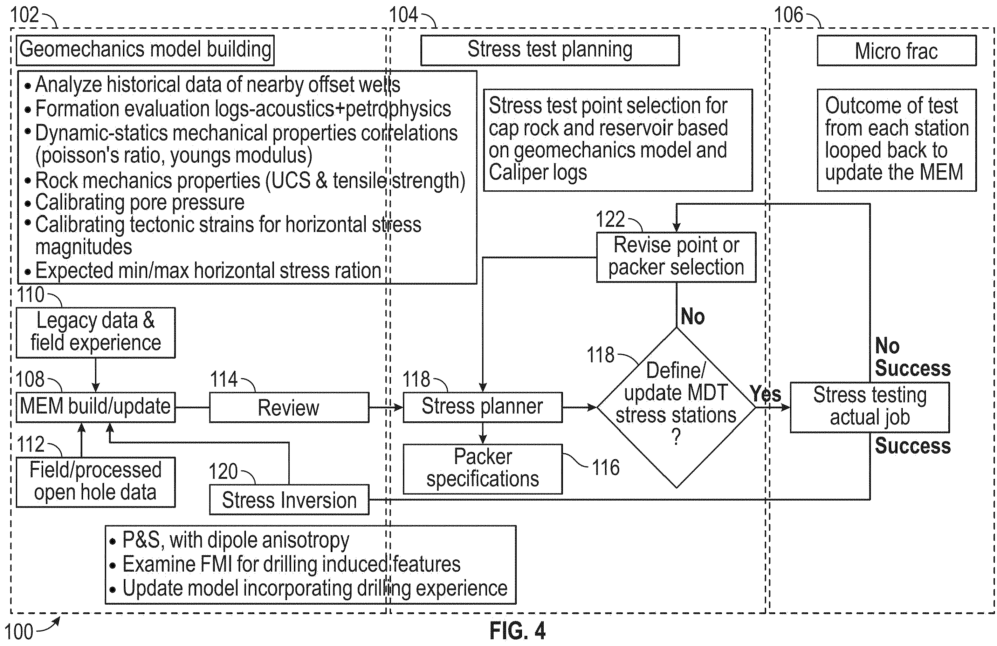

FIG. 4 illustrates an example process 100 (e.g., workflow) for implement the disclosed stress test plan using the in-situ stress testing tool of FIG. 1, in accordance with embodiments of the present disclosure. In general, the process 100 includes building, generating, or training a geomechanical model (block 102), determining a stress test plan based on the geomechanical model (block 104), and performing a fracturing operation (e.g., micro fracturing operation) (block 106). In some embodiments, the blocks 102, 104, and 106, may be performed and/or implemented may a suitable processor, such as the processor 50 and/or processor 78 of the surface control system 18. Each of the blocks 102, 104, and 106 are described in more detail below.

Building, generating, or training the geomechanical model (block 102), may include generating, at block 108, a pre-fracture mechanical earth model (MEM) using one or more data sources. In general, the data sources may include historical reference data and/or available offset well data, well logs (e.g., petrophysical logs, geophysical logs, acoustic logs). As shown, the data sources may include legacy data and/or field experience data 110 (e.g., historical reference data). Further, the data sources may include field/processor open hole data 112.

In some embodiments, generating the pre-fracture MEM may include analyzing the historical reference data of nearby offset wells. As referred to herein, a "nearby offset well" may refer to a separate or distinct well within a threshold distance from the well corresponding to where the fracturing may occur using the disclosed techniques.

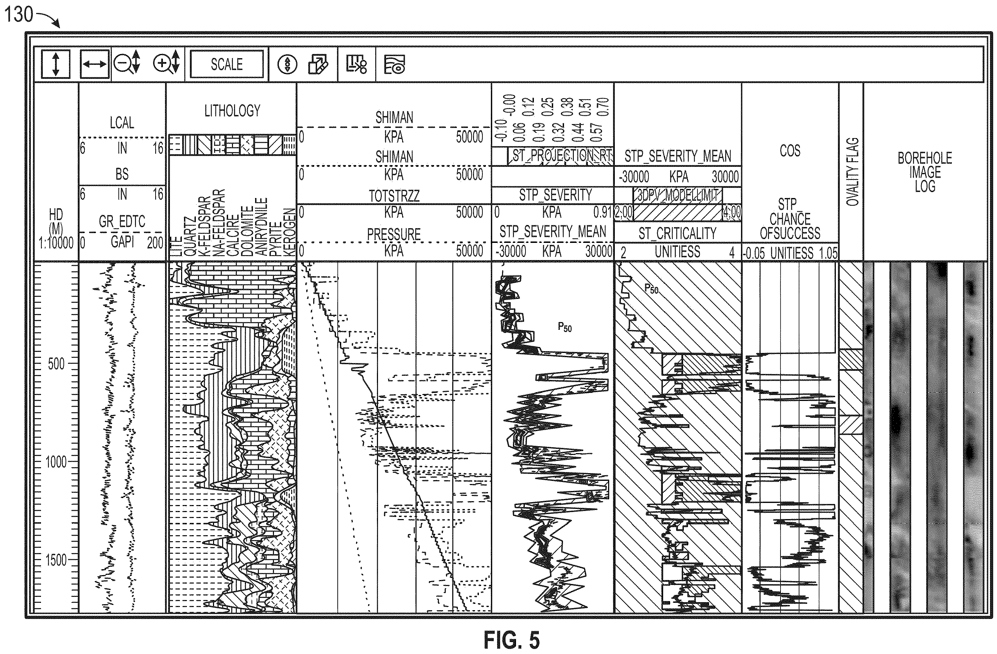

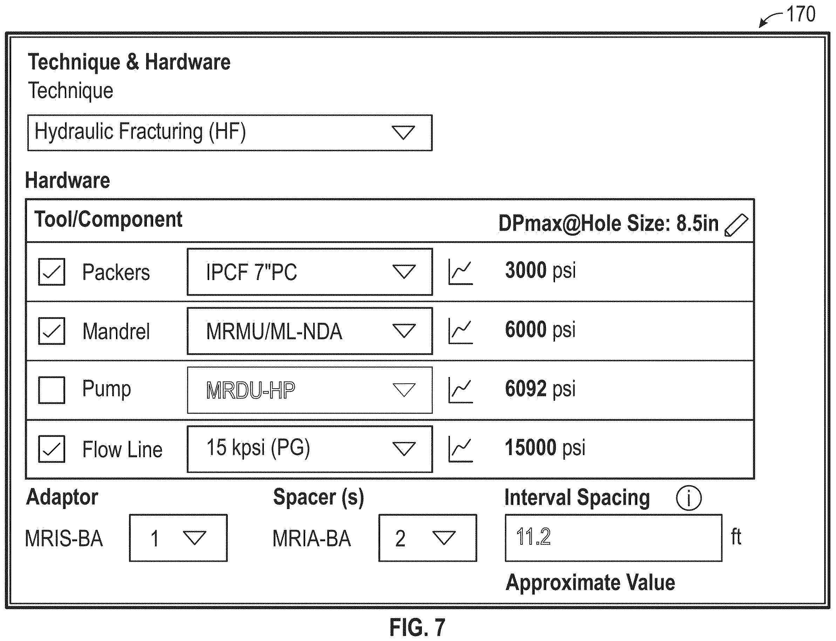

In some embodiments, the processor 50 and/or processor 78 may generate the pre-fracture MEM by building the model using mechanical properties corresponding to the wellbore. For example, the processor 50 and/or processor 78 may determine dynamic-static mechanical property correlations using such properties including, but not limited to, the Poisson's ratio, Youngs Modulus, and other properties described in more detail with respect to FIG. 7. In some embodiments, the processor 50 and/or processor 78 may generate the pre-fracture MEM using rock mechanics properties, such as the uniaxial compressive strength (UCS) and/or tensile strength of the rocks of the subterranean formation 14. For example, the processor 50 may receive a lithology log (e.g., as illustrated in FIG. 5). The lithology log may indicate relative amounts of minerals at different depths. As such, the processor 50 may determine rock mechanics properties based on the relative amounts of minerals indicated by the lithology log.

In any case, the pre-fracture MEM may be capable of calibrating for pore pressure, calibrating for tectonic strains for horizontal stress magnitudes, expected min/mix horizontal stress ratio, or a combination thereof.

A specific, but non-limiting example, of an implementation block 102 will now be described. Geomechanics model building may include construction of a pre-frac MEM based on available offset well data using available petrophysical and geophysical logs which will be propagated to the planned well location, updating of the pre-frac MEM using acquired geophysical and petrophysical data in the target well or construction of MEM from newly acquired logs in the absence of the pre-frac MEM, review, evaluate, or verify Model.

Determining the stress test plan (block 104) may include receiving tool-string information 116 (e.g., described in more detail with respect to FIG. 7). In turn, the processor 50 and/or processor 78 generates, at block 118, a stress planner that indicates a location within the wellbore 16 to perform the stress test, stress parameters, and other information described herein that are relevant for performing the stress test. Further, the processor 50 and/or processor 78 defines and/or updates modular formation dynamics test (MDT) stress stations. For example, the processor 50 may select stress test points for cap rock and reservoir based geomechanics model and caliper logs.

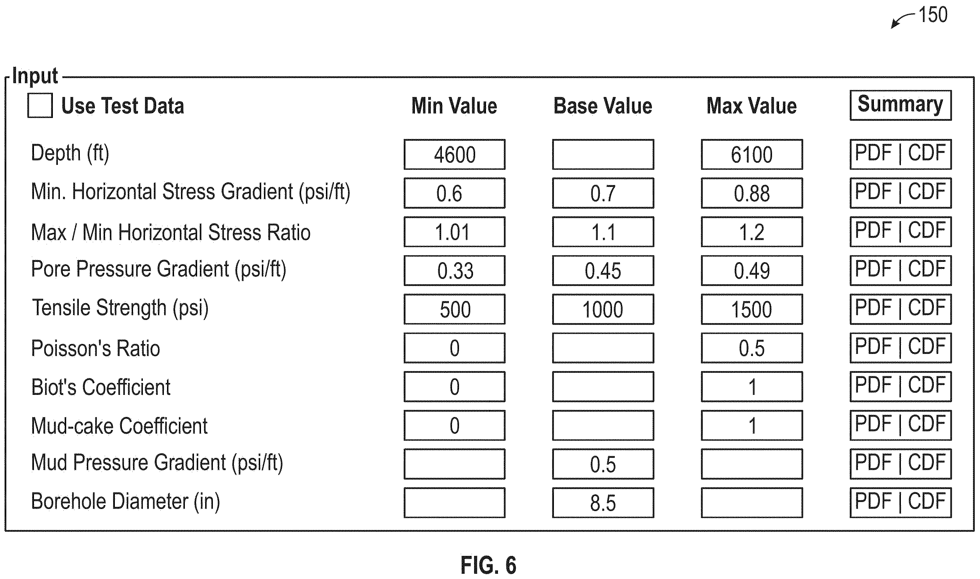

A specific, but non-limiting example, of an implementation block 104 will now be described. Based on the geomechanical model parameters (e.g., described in more detail in FIG. 6) and the specification of the tool string (e.g., described in more detail in FIG. 7) the CoS along the entire well section will be evaluated. For example, the processor 50 and/or processor 78 may determine a pressure required to achieve 95% CoS at each depth. (e.g., as illustrated in FIG. 5). The station depth may be selected based on the optimum CoS (and job priority vs. objectives), smallest pressure required to achieve 95% CoS, optimum borehole conditions based on calipers, or a combination thereof. In any case, the output of the stress test planning may include a table with CoS for each planned station based on different packer configurations.

Then, at block 106, the fracturing operation (e.g., actual stress test) is performed using the stress-test planning. If the stress-test is successful (e.g., rock is fractured), then the processor 50 and/or processor 78 may perform a stress inversion at block 120 that is used to build and update the geomechanics model at block 108. Additionally or alternatively, the processor 50 may re-calibrate the model as described in more detail below. However, if the stress-test is unsuccessful, then the process 100 proceeds to block 122 to revise point or packer selection.

A specific, but non-limiting example, of an implementation of block 106 will now be described. Based on the stress test planner summary the stress testing operation will be planned and executed. It should be noted that selection of the tool string (packer, mandrel, pump) may potentially vary for different stations or wells. As referred to herein, the "Station sequence" order of the points based on CoS. In any case, if the stress test is successful, then at block 106 the interpreted closure and breakdown pressure will be taken back into the geomechanics model for re-calibration. In some embodiments, the processor 50 may only record measurements, as compared to also interpreting the measurements. The Stress Inversion may be used to obtain the best stress calibration based on the measured data. In turn, the MEM is updated (e.g., in RT) and the stress test planner outputs are revisited and potentially updated. However, if the stress test is unsuccessful or otherwise proceeded in an unexpected way, the process may include revisiting point selection or packer selection.

FIG. 5 shows a window having representative input data that may be used to generate a model using the flow of FIG. 4, in accordance with embodiments of the present disclosure. In particular, FIG. 5 shows a window 130 that includes the MEM model, outputs of the MEM model, and input data for the MEM model. For example, the window 130 includes a first well log that illustrates lithograph at different depths within a subterranean formation 14. The window 130 also includes a chance of success (CoS) log that indicates a likelihood of success for fracturing at different depths within the subterranean formation 14. Further, the window 130 includes a borehole image log that corresponds to the wellbore 12.

FIG. 6 shows a window 150 having representative input data (e.g., geomechanical model parameters) that may be used to generate a model using the process 100 of FIG. 4, in accordance with embodiments of the present disclosure. As described above, the geomechanical model parameters may be used to evaluate a success likelihood (chance of success (Cos) at block 104 of the process 100. In some embodiments, the window 150 may be displayed on a suitable display (e.g., the display 72) aiding a user to visualize and/or input the geomechanical model parameters. As shown in the window 150, the geomechanical model parameters may include a depth, a minimum horizontal stress gradient, a maximum and/or minimum horizontal stress ratio, a pore pressure gradient, a tensile strength, a Poisson's ratio, a Biot's coefficient, a mud-cake coefficient, a mud pressure gradient, and a borehole diameter. It should be noted that the geomechanical model parameters shown in the window 150 are meant to be illustrative and non-limiting. That is, in some embodiments, one or more of the geomechanical model parameters shown may be omitted. As shown in the illustrated embodiment, each of the geomechanical model parameters may be provided as a range of values. For example, the window 150 may include a field for inputting a minimum value, base value, maximum value, or a combination thereof.

It should be noted that the processor 50 and/or the processor 78 may use well logs (e.g., as described in FIG. 5), a parameter list (e.g., the geomechanical model parameters described in FIG. 6), or both, to generate MEM model (e.g., as described in FIG. 4). For example, in an embodiment where the processor 50 generates the MEM model using well logs, the MEM model may generate a first output, such as a CoS log (e.g., as indicated in Fig.5). However, in an embodiment where the processor 50 generates the MEM model using a parameter list, then the MEM model may generate a second output, such as an average CoS for the depth indicated in the parameter list. In general, the well logs may contain specific input values measured at each depth frame, where model parameters may refer to a min & max value & statistical distribution function over a section of borehole.

FIG. 7 shows a window including tool string specifications that may be used to control the in-situ stress testing tool of FIG. 1, in accordance with embodiments of the present disclosure. As described above, the geomechanical model parameters may be used to evaluate a success likelihood chance of success (Cos) at block 104 of the process 100. More specifically, the window 170 includes tool string parameters that may provided as input and used to determine the CoS. As shown, the window 170 includes a selectable feature (e.g., a drop-down menu) that enables a user to select a particular fracturing technique (e.g., hydraulic fracturing) to be employed. Further, the window 170 includes selectable features that enable a user to select and/or visualize the packer type, mandrel type, pump type, and flow line type, to be used in the fracturing operation. The window 170 also includes selectable features that enable a user to select and/or visualize the adapter and spacer used in the fracturing operation.

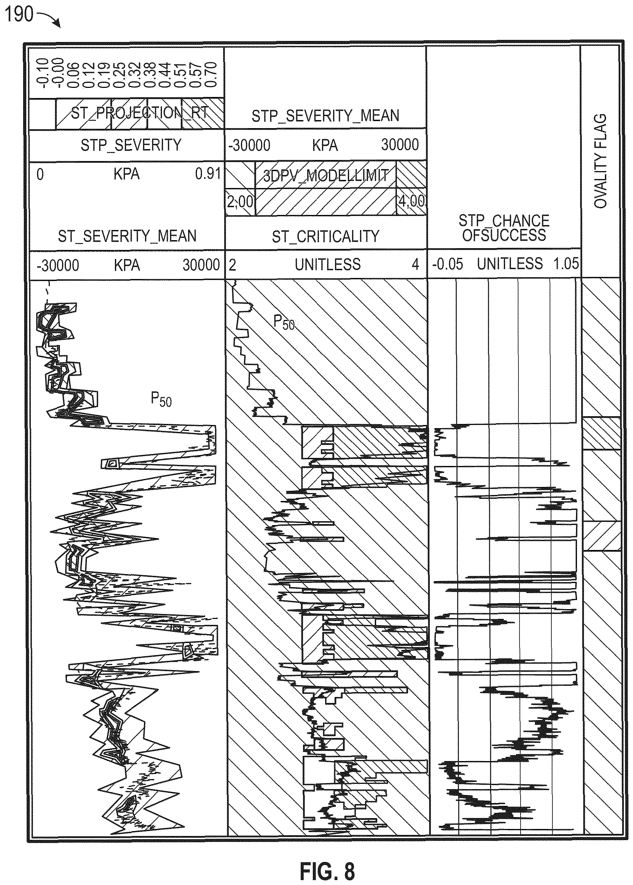

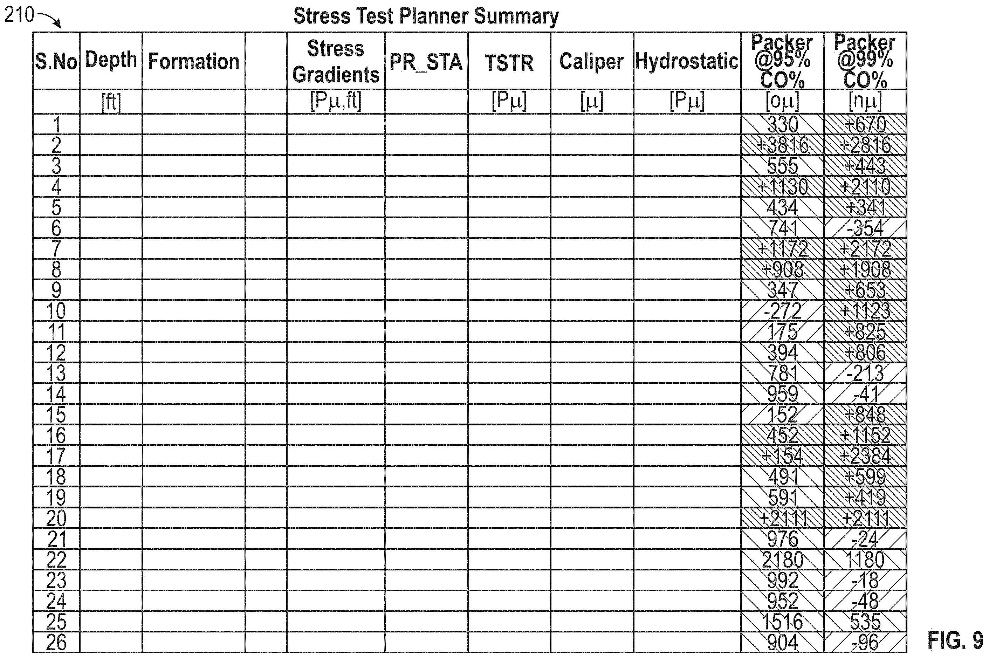

FIG. 8 shows a window 190 illustrating a determined risk profile, in accordance with embodiments of the present disclosure. In general, the window 190 shows a well log depiction of the CoS at different depths within the wellbore 16 for a stress-test planned in accordance with block 104 of the process 100. FIG. 9 shows a stress test planner summary 210, in accordance with embodiments of the present disclosure. In general, the stress test planner shows a CoS for performing a stress test at a given depth and with the parameters described with respect to FIGS. 6 and 7.

The specific embodiments described above have been illustrated by way of example, and it should be understood that these embodiments may be susceptible to various modifications and alternative forms. It should be further understood that the claims are not intended to be limited to the particular forms disclosed, but rather to cover all modifications, equivalents, and alternatives falling within the spirit and scope of this disclosure.

## Claims

1. A method, comprising:
receiving one or more inputs, wherein the one or more inputs comprise geomechanical model parameters corresponding to a subterranean formation, well logs corresponding to the subterranean formation, or both;
generating a geomechanics model using the one or more geomechanical model parameters;
receiving one or more tool-string specifications;
generating a stress test plan based on the geomechanical model and the tool-string specifications;
setting upper and lower packers of an in-situ stress testing tool at a target depth within a wellbore traversing the subterranean formation; and
injecting fluid from the in-situ stress testing tool into the subterranean formation at a downhole location within a first interval between the upper and lower packers to create and/or propagate a fracture within the subterranean formation in accordance with the stress test plan.

2. The method of claim 1, comprising iteratively conducting a plurality of cycles of potential closure and/or re-opening of the fracture while injecting the fluid from the in-situ stress testing tool into the subterranean formation.

3. The method of claim 1 or 2, comprising recording minimum stress measurements of the subterranean formation.

4. The method of any one of the preceding claims, comprising performing a stress inversion based on the fracture propagating within the subterranean formation in accordance with the stress test.

5. The method of any one of the preceding claims, wherein the geomechanical model parameters comprise a wellbore depth, a minimum horizontal stress gradient, a maximum and/or minimum horizontal stress ratio, a pore pressure gradient, a tensile strength, a Poisson's ratio, a Biot's coefficient, a mud-cake coefficient, a mud pressure gradient, a borehole diameter, or a combination thereof.

6. The method of any one of the preceding claims, wherein the one or more tool-string specifications comprise packer type, mandrel type, pump type, flow line type, or a combination thereof.

7. The method of any one of the preceding claims, further comprising generating a second output.

8. The method of claim 7, wherein the second output comprises an average chance of success for the geomechanical model parameters.

9. The method of any one of the preceding claims, further comprising determining a location within the wellbore to perform the stress test.

10. The method of any one of the preceding claims, further comprising training the geomechanics model.

11. A system, comprising:
an in-situ stress testing tool configured for insertion into a wellbore; and
a controller configured to perform a method according to any one of the preceding claims.

12. The system of claim 11, wherein the controller is configured to generate a set of training data for the geomechanics model.
